# EUROPEAN PATENT APPLICATION

(11) **EP 4 703 799 A1**
(43) Date of publication of application: **04.03.2026**
(21) Application number: 24197731.3
(22) Date of filing: 30.08.2024
(51) Int. Cl.: G03F 7/20, H01S 3/036, H01S 3/223

(54) **CATALYTIC ARRANGEMENT WITH DIFFUSION PREVENTION FOR A LASER SYSTEM, IN PARTICULAR OF A DRIVE LASER IN AN EUV LITHOGRAPHIC SYSTEM**

(71) Applicant: ASML Netherlands B.V., 5500 AH Veldhoven (NL)
(72) Inventor: VAN DRENT, William, Peter, 5500AH Veldhoven (NL); MITRAKA, EVANGELIA, 5500AH Veldhoven (NL)
(74) Representative: ASML Netherlands B.V.

(57) **Abstract**

The present invention provides a catalytic arrangement for use in a laser system, wherein the catalytic arrangement comprises:
a metal body or metal base layer,
an adhesion layer coated on the metal body or base layer, and
a catalyst layer arranged on the adhesion layer,
wherein the adhesion layer is made of a material that is substantially free of diffusion through the catalyst layer at temperatures below 300 degrees Celsius, or
wherein a diffusion barrier layer is provided between the adhesion layer and the catalyst layer, wherein the diffusion barrier layer reduces or prevents diffusion of material of the adhesion layer through the catalyst layer at temperatures below 300 degrees Celsius.

## Description

### FIELD

The present invention relates to a catalytic arrangement for use in a laser system, a laser system and a lithographic system.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

Methods to produce EUV light include, but are not necessarily limited to, converting a material into a plasma state that has an element, for example, xenon, lithium, or tin, with an emission line in the EUV range. In one such method, often termed laser produced plasma ("LPP"), the required plasma can be produced by irradiating a target material, for example, in the form of a droplet, stream, or cluster of material, with an amplified light beam that can be referred to as a drive laser. For this process, the plasma is typically produced in a sealed vessel, for example, a vacuum chamber, and monitored using various types of metrology equipment.

CO₂ amplifiers and lasers, which output an amplified light beam at a wavelength of about 10600 nm, can present certain advantages as a drive laser irradiating the target material in an LPP process. This may be especially true for certain target materials, for example, for materials containing tin. For example, one advantage is the ability to produce a relatively high conversion efficiency between the drive laser input power and the output EUV power. Another advantage of CO₂ drive amplifiers and lasers is the ability of the relatively long wavelength light (for example, as compared to deep UV at 198 nm) to reflect from relatively rough surfaces such as a reflective optic that has been coated with tin debris. This property of 10600 nm radiation can allow reflective mirrors to be employed near the plasma for, for example, steering, focusing and/or adjusting the focal power of the amplified light beam.

The laser system used to provide the drive laser may comprise at least one optical amplifier to amplify the laser beam, and a catalytic conversion system comprising a catalyst. The catalyst is configured to convert CO and O₂ to CO₂, which CO₂ in its turn is used to amplify the laser beam.

US20230400787A1 discloses a catalytic arrangement comprising such catalyst to be used in a EUV light system. The catalytic arrangement comprises a base layer of copper, an adhesion layer of nickel coated on the base layer, and a catalyst layer comprising gold as a catalyst arranged on the adhesion layer.

The catalytic activity of this catalytic arrangement has been shown to decrease over time. This reduces the performance of the laser system and may even result in the need to replace the catalyst after a certain period of time.

### SUMMARY

It is an object of the invention to provide an improved catalytic arrangement that can be used in a laser system, in particular a laser system configured to provide a drive laser in an EUV lithographic system.

According to an aspect of the invention, there is provided a catalytic arrangement for use in a laser system, wherein the catalytic arrangement comprises:
a metal body or metal base layer,
an adhesion layer coated on the metal body or base layer, and
a catalyst layer comprising a catalyst arranged on the adhesion layer,
wherein the adhesion layer is made of a material that is substantially free of diffusion through the catalyst layer at temperatures below 300 degrees Celsius, or
wherein a diffusion barrier layer is provided between the adhesion layer and the catalyst layer, wherein the diffusion barrier layer reduces or prevents diffusion of material of the adhesion layer through the catalyst layer at temperatures below 300 degrees Celsius.

According to an aspect of the invention, there is provided a laser system having a catalytic conversion system comprising a catalytic arrangement for use in a laser system, wherein the catalytic arrangement comprises:
a metal body or metal base layer,
an adhesion layer coated on the metal body or base layer, and
a catalyst layer comprising a catalyst arranged on the adhesion layer,
wherein the adhesion layer is made of a material that is substantially free of diffusion through the catalyst layer at temperatures below 300 degrees Celsius, or
wherein a diffusion barrier layer is provided between the adhesion layer and the catalyst layer, wherein the diffusion barrier layer reduces or prevents diffusion of material of the adhesion layer through the catalyst layer at temperatures below 300 degrees Celsius.

According to an aspect of the invention, there is provided a lithographic system comprising such laser system and a lithographic apparatus, in particular an extreme ultraviolet lithographic apparatus.

### BRIEF DESCRIPTION OF THE DRAWINGS

Embodiments of the invention will now be described, by way of example only, with reference to the accompanying schematic drawings, in which:
- Figure 1 depicts schematically a lithographic system comprising a lithographic apparatus and a radiation source;
- Figure 2 depicts a schematically an embodiment of an extreme ultraviolet light system comprising a laser system;
- Figure 3A depicts schematically a graph of power output from an optical amplifier of the laser system versus the duty cycle of the optical amplifier without using a catalytic conversion system;
- Figure 3B depicts schematically a graph of power output from an optical amplifier of the laser system versus the duty cycle of the optical amplifier using a catalytic conversion system;
- Figure 4 depicts schematically an optical amplifier system that can be used in the laser system of Figure 2;
- Figure 5 depicts schematically a known art catalytic arrangement for use in an optical amplifier system;
- Figure 6 depicts schematically a catalytic arrangement for use in an optical amplifier system according to an embodiment of the invention; and
- Figure 7 depicts schematically a catalytic arrangement for use in an optical amplifier system according to an alternative embodiment of the invention;

### DETAILED DESCRIPTION

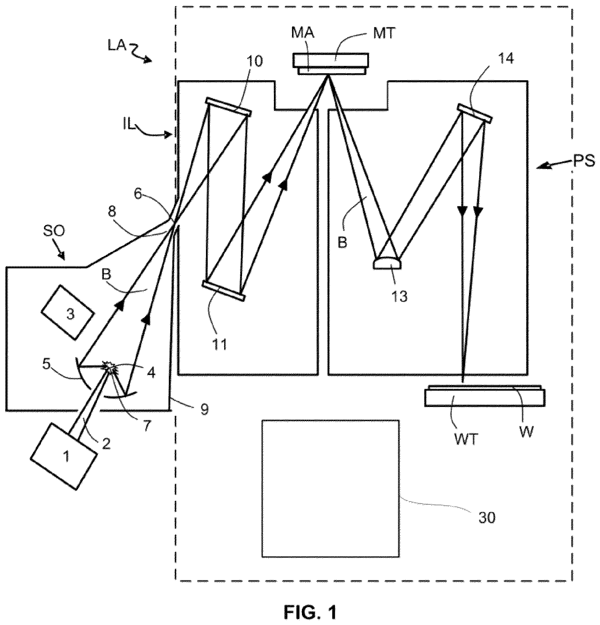

Fig. 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Fig. 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

The radiation source SO shown in Figure 1 is, for example, of a type which may be referred to as a laser produced plasma (LPP) source. A laser system 1, which may, for example, include a CO2 laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

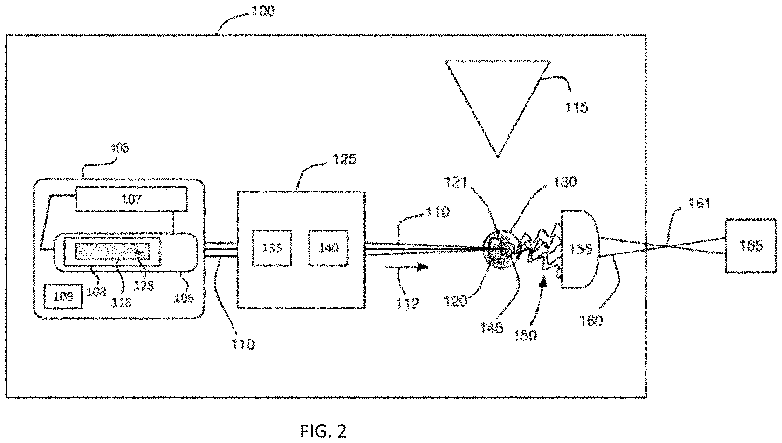

Fig. 2 depicts an extreme ultraviolet (EUV) light system 100 in more detail. The EUV light system 100 includes a laser system 105 that produces a drive laser, i.e. an drive laser 110, a target material delivery system 115 configured to produce a target material 120, and a beam delivery system 125 that is configured to receive the drive laser 110 emitted from the laser system 105 and to direct the drive laser 110 toward a target location 130, which receives the target material 120. The beam delivery system 125 includes a beam transport system 135 and a final focus assembly 140 that focuses the drive laser 110 at a focal location 145. The interaction between the drive laser 110 and the target material 120 produces plasma 121 that emits EUV light or radiation 150. A light collector 155 collects and directs collected EUV light 160 toward an optical apparatus 165 such as a lithography tool.

The laser system 105 includes an optical amplifier system 106 along with other optical components such as pre- amplifiers. The optical amplifier system 106 includes at least one optical amplifier 108 having a gain medium 128, which is a gas mixture of molecules capable of optically amplifying the desired wavelength at a high gain, an excitation source such as an electrical source, and internal optics. The gain medium 128 within the optical amplifier 108 is contained within an enclosed volume 118 such as a tube. During electrical pumping of the gain medium 128 of the optical amplifier 108, at least some of the molecules of the gain medium 128 dissociate into one or more molecules or elements that are not involved in the optical amplification, and because of this, the optical amplifier 108 produces less power, which means that the drive laser 110 has a lower power. In this case, the interaction between the drive laser 110 and the target material 120 ultimately produces less plasma 121, which reduces the amount of EUV light 150 emitted, which reduces the collected EUV light 160 that can be used by the optical apparatus 165. This effect is even more pronounced in a pulsed system in which the electrical source is turned on for periods of time interspersed with times in which it is turned off.

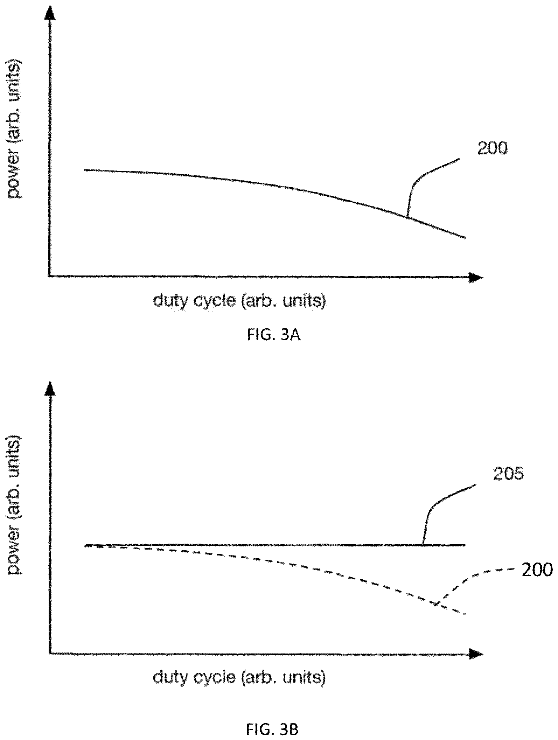

Referring to Fig. 3A, as the duty cycle of the optical amplifier 108 is increased (by increasing the duty cycle of the electrical source), the dissociation of the molecules in the gain medium 128 rises and the power output 200 from the optical amplifier 108 drops off. The duty cycle is the ratio of the time [T(on)] the input power is applied to the electrodes in a cycle over the total time [T(on+off)] in the cycle: T(on)/T(on+off). For example, the optical amplifier 108 can include as the gain medium 128 a gas mixture that includes carbon dioxide (CO₂) mixed with other molecules or elements such as helium (He), nitrogen (N₂), hydrogen (H₂), or water (H₂O). When the optical amplifier 108 is electrically pumped using a gas discharge, energy is transferred to the CO₂ molecules, and more and more of these CO₂ molecules dissociate into carbon monoxide (CO) and oxygen (O₂) as the duty cycle is increased.

Unless the dissociated molecules are converted back into the original molecules of the gas mixture that are used for optical amplification, the output power of the laser system 105 will remain unacceptably low, especially as the duty cycle is increased. The process of converting the dissociated molecules back into the original molecules is done via catalytic conversion. The laser system 105 includes a catalytic conversion system 107 that receives the gas mixture that includes the dissociated molecules from the optical amplifier 108, performs the step or steps involved in catalytic conversion (for example, oxidation) of the molecules into the original molecules that contribute to optical amplification, and re-introduces this gas mixture back into the optical amplifier 108. The catalytic conversion system 107 is fluidly connected to the enclosed volume 118 that houses the gain medium 128 at a first end to enable the gas mixture (which contains the excess of dissociated molecules) of the gain medium 128 to flow from the optical amplifier 108 to the catalytic conversion system 107 and at a second end to enable the gas mixture (which has been oxidized) from the catalytic conversion system 107 to the optical amplifier 108. Referring to Fig. 3B, in this way, the gas mixture is effectively maintained with the original molecules that contribute to optical amplification, and the power output 205 from the laser system 105 can be maintained at a suitable level, even as the duty cycle is increased. Moreover, the power output can be maintained without having to raise the amount of energy applied to the excitation source of the optical amplifier 108 and without having to add additional gas mixture with oxidized molecules into the fluid lines (for example, the tube that houses the gain medium of the optical amplifier 108). The dashed line shown in Fig. 3B shows the power output 200 from Fig. 3A overlaid on the graph for comparison.

The laser system 105 can also include a controller 109 that performs various tasks such as monitoring components within the optical amplifier 108 and the catalytic conversion system 107, performing analysis or calculations based on the monitored information, and providing instructions to components within the laser system 105 based on the results of the analysis or calculations.

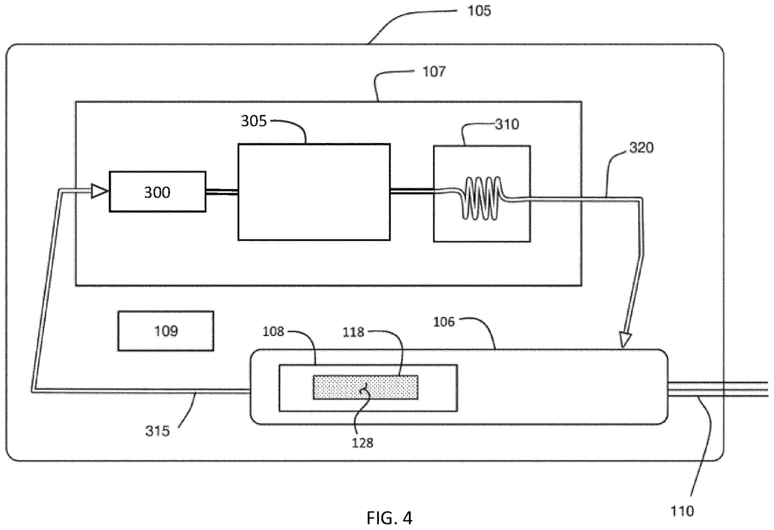

Referring to Fig. 4, an exemplary catalytic conversion system 107 can be designed as a part of or in combination with an external cooler or heat exchanger system that removes excess heat from the gas mixture that is produced during operation of the optical amplifier 108. In this example, the catalytic conversion system 107 optionally includes a gas pre-heater 300, a catalytic converter 305, and a heat exchanger 310. The gas mixture from the optical amplifier 108 flows out of the enclosed volume 118 of the optical amplifier 108 through an enclosed pipe or tube 315 toward the catalytic conversion system 107, and the gas mixture from the catalytic conversion system 107 flows through enclosed pipe or tube 320 and into the enclosed volume 118 of the optical amplifier 108 to be reused during operation and production of the drive laser 110. The pipes 315, 320 can be made of a material such as, for example, stainless steel, aluminum, or metal alloy, which do not react with the gas mixture that flows through the pipes 315, 320.

The gas pre-heater 300 can be used to raise and regulate the temperature of the gas mixture before and as it enters the catalytic converter 305, thus improving the conversion efficiency within the catalytic converter 305. In particular, by heating the dissociated gas mixture before it enters the catalytic converter 305, the temperature of the dissociated gas mixture can be maintained at a temperature at which the catalyst within the catalytic converter 305 is most effective in causing or accelerating oxidation of the dissociated molecules within the gas mixture. Thus, for example, the controller 109 could monitor the temperature of the gas mixture within the pipe 315, determine whether the temperature is at an optimum value at which the catalyst is most effective, and, if the temperature is below that optimum value, the controller 109 could send a signal to the pre-heater 300 to raise the temperature of the gas mixture to a particular value.

In general, the higher the temperature of the gas mixture, the higher the catalytic efficiency. For example, the catalytic reaction rate within a gas mixture can double with every 10 degrees centigrade rise in temperature applied to the gas mixture. If the catalytic elements are installed inside a CO₂ laser or amplifier, then depending on the laser configuration, the temperature of the gas mixture can rise to 60 degrees centigrade In another application, a fraction of the laser gas mixture (for example, less than about 10 percent) can be bled off in a close-loop circulation system, through an external catalytic converter, in which case the temperature of the gas mixture can be raised to any desired level (such as, for example, 100 degrees C). Some catalytic converters (such as those in the automotive industry or in early CO₂ laser systems) operate at temperatures much greater than this level, for example, around 240 degrees centigrade Using a high-efficiency material for the catalyst acts to reduce the requirement for high gas temperature to effect high catalytic conversion efficiency. In the system 100 and method described herein, the temperature set-point for the gas mixture is determined by balancing the efficiency of the heat exchanger 310 within the catalytic conversion system 107 with the need to increase the rate of catalytic conversion of CO and O₂ to CO₂. This can be done by conducting a systematic study of the power output from the optical amplifier 108, the power output being a function of the temperature of the gas mixture that is output from the heat exchanger 310, and the concentration of CO and/or O₂ versus the temperature of the gas mixture at the input to the catalytic converter 35.

The heat exchanger 310 can be any suitable device that removes heat from the gas mixture. In some implementations, the heat exchanger 310 is hollow tubing through which the gas mixture flows, the exterior surface of the hollow tubing being cooled by a fluid such as water. In some implementations, the heat exchanger 310 can further be provided on its interior with a catalyst such as gold, for example plated gold, to provide catalytic conversion of the gas mixture that flows through the tubing of the heat exchanger 310. Thus, the catalyst on the interior of the hollow tubing accelerates or causes the oxidation of the dissociated molecules within the gas mixture.

Thus, in summary, the catalytic conversion system 107 contains the gas pre-heater 300 to heat the gas mixture to a stable temperature (and maintain it at this stable temperature) so that the catalytic efficiency within the catalytic converter 305 is near or at its highest point; the catalytic converter 305 containing an active catalyst downstream from the gas pre- heater 300. Both the gas pre -heater 300 and the catalytic converter 305 can be placed upstream of the heat exchanger 310. The heat exchanger 310 provided with a catalyst can therefore act as a second stage of the catalytic conversion within the catalytic conversion system 107.

In alternative embodiments, only the catalytic converter 305 or the heat exchanger 310 may comprise a catalyst. In case only the heat exchanger 310 comprises a catalyst, the catalytic converter 305 may be omitted.

Additional details about the EUV light system 100 and its implementation in a lithographic system are for example disclosed in WO2015113843A1 and US20230400787A1, the contents of which are herein incorporated in its entirety by reference.

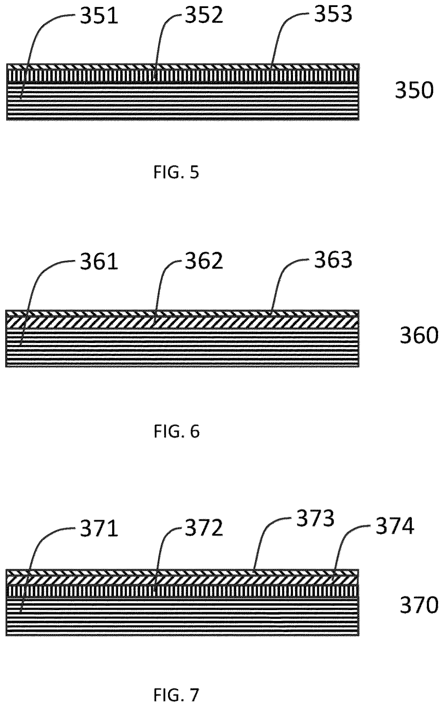

Fig. 5 shows a catalytic arrangement 350 to be used in an extreme ultraviolet light system as disclosed in US20230400787A1. The catalytic arrangement comprises a base layer 351 of copper (Cu), an adhesion layer 352 of nickel (Ni) coated on the base layer 351, and a catalyst layer 353 comprising the catalyst arranged on the adhesion layer 352. The adhesion layer 352 is provided to improve the adhesion of the base layer 351 and the catalyst layer 353. The catalyst is gold (Au). This catalytic arrangement 350 may for example be arranged on the inner surface of spirally shaped tubes of the heat exchanger 310 or within the catalytic converter 305. The base layer 351 may be a separate layer or be part of the material on which the catalytic arrangement 350 is arranged. The copper (Cu) of the base layer 351 may for example form the main body of a spirally shaped tube of the heat exchanger 310. Any other suitable metal may also be used for the base layer 351.

It has been found that nickel (Ni) of the adhesion layer 352 may diffuse over time through a gold catalyst layer 353, in particular at elevated temperatures, for example above 100 degrees Celsius, such as 200 degrees Celsius or above. The temperature in a heat exchanger tube of the heat exchanger 310 in which the catalytic arrangement 350 is provided may in practice be between 200 and 220 degrees Celsius during operation.

This diffusion of the nickel (Ni) through the gold catalyst layer 353 may take weeks or longer and may depend on the temperature of the catalytic arrangement 350. As a result of the nickel of the adhesion layer 352 diffusing through the gold catalyst layer 353 a nickel layer may grow on top of the gold catalyst layer 353. This nickel layer on top of the gold catalyst layer 353 will reduce the exposed surface area of the catalyst. As a consequence, the catalytic activity of the catalyst may be reduced.

Fig. 6 shows a catalytic arrangement 360 according to an embodiment of the invention. This catalytic arrangement 360 comprises a metal body or metal base layer 361 made of copper (Cu) or any other suitable metal, an adhesion layer 362 coated on the metal body or base layer 361, the adhesion layer 362 being made of chromium (Cr), and a catalyst layer 363 comprising the catalyst arranged on the adhesion layer 362. The adhesion layer 362 is provided to improve the adhesion of the base layer 361 and the catalyst layer 363. The adhesion layer 362 is made of chromium (Cr) instead of nickel (Ni). Chromium (Cr) is a material that is substantially free of diffusion through the catalyst layer at least at temperatures below 300 degrees Celsius. As chromium (Cr) is used as material for the adhesion layer 362, the material of the adhesion layer will, for example at temperatures below 300 degrees Celsius, such as temperatures between 50 degrees Celsius and 280 degrees Celsius, no longer diffuse through the catalyst layer 363 to form a layer of adhesion material on top of the catalyst layer 363. The catalytic activity of the catalyst will therefore not be reduced by presence of the material of the adhesion layer 362 on top of the catalyst layer 363.

Instead of chromium (Cr) as a material for the adhesion layer 362 any other material that is suitable as an adhesion layer 362 between the body or base layer 361 and the catalyst layer 363 and that is substantially free of diffusion through the catalyst layer 363 at temperatures below 300 degrees Celsius, for example between 50 and 280 degrees Celsius may also be used. Substantially free of diffusion means that the rate of diffusion is substantially smaller than the rate of diffusion of nickel (Ni) through a gold (Au) catalyst layer with same thickness of the adhesion layer and catalyst layer and at the same temperature. Advantageously, there is no diffusion of the material of the adhesion layer 362 through the catalyst layer 363. In practice, the diffusion of the material of the adhesion layer 362 of the catalytic arrangement of the invention is advantageously at or below a level at which it has no substantial effect on the lifetime performance of the catalyst of the catalytic arrangement 360.

Another material that for example may be used as material for the adhesion layer is titanium (Ti).

The catalyst may be any suitable catalyst material, such as precious metals and/or noble metals, or combinations thereof. Typical materials used as catalyst are gold (Au), platinum (Pt), silver (Ag), or combinations thereof. Oxides of precious and/or noble metals may also be suitable as a catalyst material.

The catalyst may be provided as gold (Au) deposited in the catalyst layer 363 or as a solid gold (Au) layer, for example as a gold-plated layer on the adhesion layer 362. The gold-plated layer may be an electroplated gold layer. The thickness of the gold-plated catalyst layer 363, for example as an electroplated gold layer, may be in the range of 50 nm to 300 nm for example in the range of 80 nm to 200 nm.

The catalyst layer 363 may be textured to increase surface area of the catalyst layer 363 and therewith increase the catalytic activity of the catalyst of the catalyst layer 363.

Fig. 7 shows a catalytic arrangement 370 according to an alternative embodiment of the invention. The catalytic arrangement 370 comprises a base layer 371 of copper (Cu), an adhesion layer 372 of nickel (Ni) and a catalyst layer 373 comprising the catalyst, for example gold (Au). To reduce or prevent diffusion of nickel through the catalyst layer 373, a diffusion barrier layer 374 is provided between the adhesion layer 372 and the catalyst layer 373. The diffusion barrier layer 374 is made of a material that is substantially free of diffusion through the catalyst layer 373 at temperatures below 300 degrees Celsius, for example between 50 and 280 degrees Celsius. The material of the diffusion barrier layer 374 is for example palladium (Pd), chromium (Cr) or titanium (Ti), or a combination thereof. Any other suitable material may also be used for the diffusion barrier layer 374.

The catalytic arrangements 360, 370 of Fig. 6 and Fig. 7 may for example be arranged on the inner surface of spirally shaped tubes of the heat exchanger 310 and/or in the catalytic converter 305 of the catalytic conversion system 107 shown in Figure 4 to extend the long term performance of the catalytic activity of the respective catalytic arrangement 360, 370.

The catalytic arrangements 360, 370 may be applied in an optical amplifier system of a laser system, in particular a laser system for an EUV lithographic system.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A catalytic arrangement for use in a laser system, wherein the catalytic arrangement comprises:
a metal body or metal base layer,
an adhesion layer coated on the metal body or base layer, and
a catalyst layer comprising a catalyst arranged on the adhesion layer,
wherein the adhesion layer is made of a material that is substantially free of diffusion through the catalyst layer at temperatures below 300 degrees Celsius, or
wherein a diffusion barrier layer is provided between the adhesion layer and the catalyst layer, wherein the diffusion barrier layer reduces or prevents diffusion of material of the adhesion layer through the catalyst layer at temperatures below 300 degrees Celsius.

2. The catalytic arrangement of claim 1, wherein the catalyst comprises gold (Au), platinum (Pt), silver (Ag), or combinations thereof.

3. The catalytic arrangement of claim 1 or 2, wherein the catalyst layer comprises a gold (AU) layer covering the adhesion layer or the diffusion barrier layer.

4. The catalytic arrangement of any of the claims 1-3, wherein the catalyst layer is an electroplated gold (Au) layer.

5. The catalytic arrangement of any of the claims 1-4, wherein the adhesion layer comprises chromium (Cr) and/or titanium (Ti).

6. The catalytic arrangement of any of the claims 1-4, wherein the adhesion layer comprises nickel (Ni) and the diffusion barrier layer comprises palladium (Pd), chromium (Cr) and/or titanium (Ti).

7. The catalytic arrangement of any of the claims 1-6, wherein the catalytic arrangement is provided on an inner surface or an outer surface of a heat exchange conduit of a heat exchanger.

8. The catalytic arrangement of claim 7, wherein the heat exchange conduit is a spirally shaped tube.

9. The catalytic arrangement of claim 7 or 8, wherein the heat exchanger is part of a catalytic conversion system of a laser system.

10. The catalytic arrangement of any of the preceding claims, wherein the diffusion barrier layer is made of a material that is substantially free of diffusion through the catalyst layer.

11. A laser system having an optical amplifier system comprising the catalytic arrangement of any of the preceding claims.

12. The laser system of claim 11, wherein the optical amplifier system comprises:
at least one optical amplifier to amplify the laser beam, and
at least one catalytic conversion system associated with the at least one optical amplifier, the catalytic conversion system comprising the catalytic arrangement.

13. The laser system of claim 12, wherein the laser system comprises an optical amplifier chain comprising two or more optical amplifiers.

14. An Extreme Ultraviolet, EUV, source comprising a target material delivery system, and a laser system according to any of claims 11-13, wherein the laser system is arranged to irradiate a target material output by the target material delivery system.

15. A lithographic system comprising:
a laser system as claimed in any of the claims 11-13, and
a lithographic apparatus, for example an extreme ultraviolet lithographic apparatus.
